# EUROPEAN PATENT APPLICATION

(11) **EP 1 254 969 A1**
(43) Date of publication of application: **06.11.2002**
(21) Application number: 02076471.8
(22) Date of filing: 15.04.2002
(51) Int. Cl.: C23C 14/24, C23C 14/26, C23C 14/12

(54) **PVD vapor source**

(30) Priority: 26.04.2001 US 843489
(71) Applicant: EASTMAN KODAK COMPANY, Rochester, New York 14650-2201 (US)
(72) Inventor: Van Slyke, Steven A., Rochester, New York 14650-2201 (US); Shore, Joel D., Rochester, New York 14650-2201 (US); Pignata, Angelo G., Rochester, New York 14650-2201 (US)
(74) Representative: Nunney, Ronald Frederick Adolphe

(57) **Abstract**

Apparatus includes a tubular source for thermal physical vapor deposition of organic layers in making organic light-emitting devices defines a cavity for receiving organic material. The tubular source (210) is controllably heated to vaporize the organic material in the cavity (212) and to provide a vapor stream exiting the cavity through a line of openings (214) extending into the cavity. The apparatus defines a reduced pressure chamber having the tubular source and an OLED structure on which is deposited an organic layer. Relative motion between the source and the structure ensures that a relatively uniform layer of organic material is deposited on the structure.

## Description

The present invention relates to physical vapor deposition of organic layers in manufacture of organic light-emitting devices, and more particularly to apparatus which includes a linear tubular source for thermal physical vapor deposition of such organic layers.

An organic light-emitting device, also referred to as an organic electroluminescent device, can be constructed by sandwiching two or more organic layers between first and second electrodes.

In a passive matrix organic light-emitting device (OLED) of conventional construction, a plurality of laterally spaced light-transmissive anodes, for example indium-tin-oxide (ITO) anodes, are formed as first electrodes on a light-transmissive substrate such as, for example, a glass substrate. Two or more organic layers are then formed successively by vapor deposition of respective organic materials from respective sources, within a chamber held at reduced pressure, typically less than 10⁻³ Torr. A plurality of laterally spaced cathodes are deposited as second electrodes over an uppermost one of the organic layers. The cathodes are oriented at an angle, typically at a right angle, with respect to the anodes.

Such conventional passive matrix organic light-emitting devices are operated by applying an electrical potential (also referred to as a drive voltage) between appropriate columns (anodes) and, sequentially, each row (cathode). When a cathode is biased negatively with respect to an anode, light is emitted from a pixel defined by an overlap area of the cathode and the anode, and emitted light reaches an observer through the anode and the substrate.

In an active matrix organic light-emitting device (OLED), an array of anodes are provided as first electrodes by thin-film transistors (TFTs) which are connected to a respective light-transmissive portion. Two or more organic layers are formed successively by vapor deposition in a manner substantially equivalent to the construction of the aforementioned passive matrix device. A common cathode is deposited as a second electrode over an uppermost one of the organic layers. The construction and function of an active matrix organic light-emitting device is described in US-A-5,550,066, the disclosure of which is herein incorporated by reference.

Organic materials, thicknesses of vapor-deposited organic layers, and layer configurations, useful in constructing an organic light-emitting device, are described, for example, in US-A-4,356,429; US-A-4,539,507; US-A-4,720,432; and US-A-4,769,292, the disclosures of which are herein incorporated by reference.

Thermal physical vapor deposition is a well-known technique for coating a substrate or structure with a material that is held in a container, the deposition source, and which is heated to the point at which vaporization (by evaporation or by sublimation) of the material occurs. The vapor leaves the deposition source and condenses on a substrate or structure to be coated with a layer of the material.

Various configurations of deposition sources have been contemplated or are commercially available for thermal physical vapor deposition of inorganic materials, metals and metal alloys, and organic materials. Such known deposition sources are frequently designed for particular applications, for example, metallization of a structure, fabrication of organic protective layers, or deposition of inorganic layers on a structure.

Thermal physical vapor deposition of organic materials, and more particularly of organic materials useful in making organic light-emitting devices, pose several challenges. Such organic materials can have relatively complex molecular structures with relatively weak molecular bonding forces, so that care must be taken to avoid decomposition of the organic material(s) during the vaporization process. Additionally, many organic materials are relatively poor thermal conductors, particularly when in a powder- or flake-form, thereby limiting the utility of conventional deposition sources for reasons related to spatially non-uniform heating of organic materials in such sources with attendant spatially non-uniform vaporization of organic material and, therefore, potentially non-uniform vapor-deposited organic layers formed on a substrate or structure.

Such potential non-uniformity of organic layers can become more pronounced, or even detrimental, when substrates or structures of relatively larger dimensions or areas are to be coated with one or several organic layers.

A well-established approach to achieving coatings or layers of uniform thickness on a substrate or structure having relatively large dimensions is based on positioning a deposition source with respect to the substrate so that the source is spaced in a vertical direction from the substrate by a relatively large distance, and is offset in a lateral direction with respect to a center of the substrate. The substrate or structure is then rotated, frequently in a so-called planetary or orbital motion, and vapor deposition commences. Thickness uniformity of a layer generally increases with increasing lateral offset between the source and the center of the substrate to be coated up to a distance where a center of the deposition source is approximately congruent with an outer edge of the rotating substrate.

A disadvantage of the above-described approach is that much of the material to be vaporized by the source is wasted in the form of deposits formed in other portions of a deposition chamber. Such waste of material may be acceptable when the cost of a starting material is relatively low. However, such waste becomes a significant problem in cases where relatively expensive, highly purified and relatively complex organic materials are used to form, for example, organic layers in an organic light-emitting device.

It is an object of the present invention to provide an apparatus for thermal physical vapor deposition of organic layers in manufacture of organic light-emitting devices.

It is another object of the present invention to provide an apparatus for forming an organic layer on a structure as part of an organic light-emitting device.

It is a further object of the invention to provide a tubular thermal physical vapor deposition source for forming organic layers in manufacture of organic light-emitting layers.

These and other objects of the present invention are achieved in an apparatus for vapor-depositing an organic layer onto a structure which will provide part of an organic light-emitting device, comprising:
a) a housing defining a chamber and a pump connected to the chamber for producing a reduced pressure therein, the structure being positioned in the chamber in a deposition zone;
b) a tubular thermal physical vapor deposition source disposed in the chamber and spaced from the structure, the source defining a cavity for receiving organic material to be vaporized, and the organic material having a vapor pressure which is substantially greater than the reduced pressure in the chamber;
c) the tubular physical vapor deposition source defining a line of openings extending into the cavity, the line of openings being arranged so that vaporized organic material is deposited into the deposition zone onto the structure;
d) means for controllably heating the tubular vapor deposition source to cause the organic material to form a vapor at a controlled rate, the vapor being distributed throughout the cavity and exiting the cavity through the line of openings at a controlled rate; and
e) means for providing relative linear motion between the tubular vapor deposition source and the structure so that the vapor of organic material in the deposition zone causes formation of a uniformly thick vapor-deposited organic layer on the structure.

### ADVANTAGES

A feature of the present invention is that the tubular vapor deposition source can be readily scaled with respect to the dimensions of substrates or structures which are to receive an organic layer.

Another feature of the present invention is that a tubular vapor deposition source can readily be heated for effective deposition of organic material.

Another feature of the present invention is that a tubular vapor deposition source can be disposed at relatively close spacing with respect to a substrate or structure so that an organic layer can be deposited on the substrate or structure with reduced waste of organic material.
FIG. 1 is a schematic perspective view of a passive matrix organic light-emitting device having partially peeled-back elements to reveal various layers;
FIG. 2 is a schematic perspective view of a apparatus suitable for making relatively large numbers of organic light-emitting devices (OLEDs) and having a plurality of stations extending from hubs;
FIG. 3 is a schematic section view of a carrier containing a relatively large number of substrates or structures, and positioned in a load station of the system of FIG. 2 as indicated by section lines 3-3 in FIG. 2;
FIG. 4A is a schematic plan view of a single OLED device substrate;
FIG. 4B is a schematic plan view of a multiple-device substrate;
FIG. 5 shows a partially sectioned top view of one embodiment of a tubular thermal physical vapor deposition source assembly which includes a cylindrical tubular source heatable by heat lamps, in accordance with an aspect of the present invention;
FIG. 6 is a schematic section view of the assembly taken along the section lines 6-6 of FIG. 5;
FIG. 7 is a schematic section view of a vapor deposition station dedicated to forming vapor-deposited organic hole-transporting layers (HTL) on a substrate or structure in the system of FIG. 2 as indicated by section lines 7-7 in FIG. 2, and showing schematic end views of the assembly of FIG. 5 being moved by a lead screw to provide a uniformly vapor-deposited organic hole-transporting layer over the substrate or structure;
FIG. 8 shows a schematic top view of a portion of the HTL vapor deposition station of FIG. 2, and indicating forward and reverse motion of the assembly of FIG. 5 from and to a parked position in which vapor deposition is monitored by a sensor, in accordance with an aspect of the present invention;
FIG. 9 is a schematic longitudinal section view of the assembly of FIG. 5 operative in the HTL vapor deposition station of FIG. 2, and showing vapor of organic hole-transporting material inside a cavity of a tubular source and vapor exiting the source through a line of openings to define a deposition zone, in accordance with an aspect of the present invention;
FIG. 10 is a schematic exploded perspective view of another embodiment of a tubular thermal physical vapor deposition source assembly which includes a rectangular tubular source heatable by heat lamps and a heat shield having a cooling coil on an outer surface, in accordance with an aspect of the invention;
FIGS. 11A and 11B are schematic top views of another embodiment of a tubular thermal physical vapor deposition source assembly in which a tubular source is heatable by a heating element, wherein

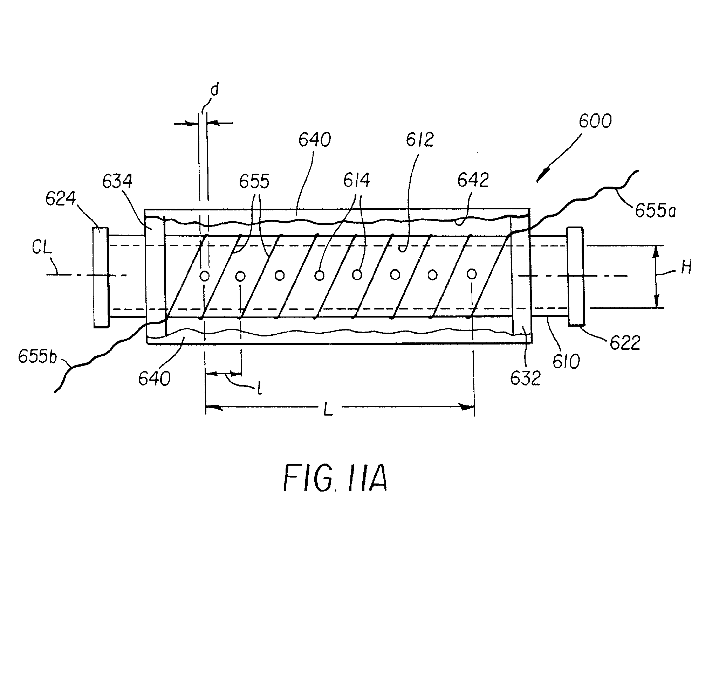

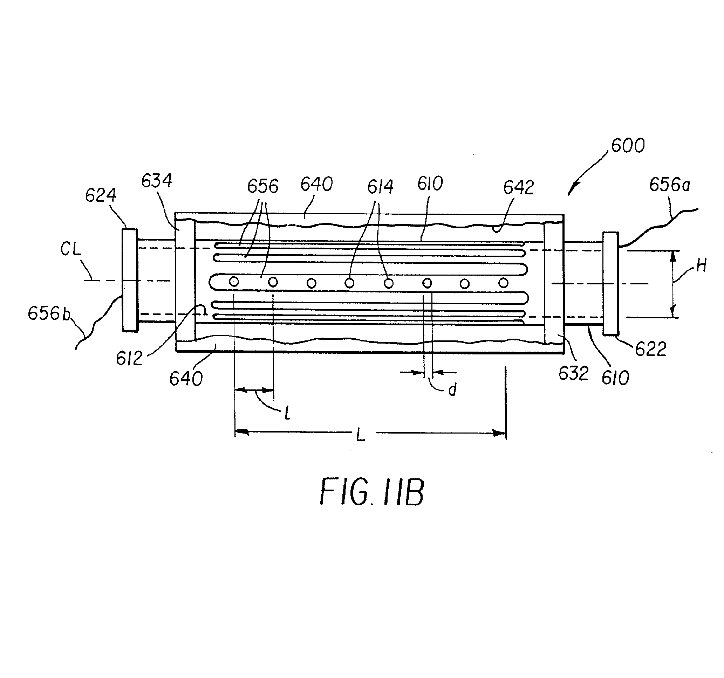

FIG. 11A depicts a spiral heating element, and
FIG. 11B shows a serpentine heating element, in accordance with an aspect of the present invention;

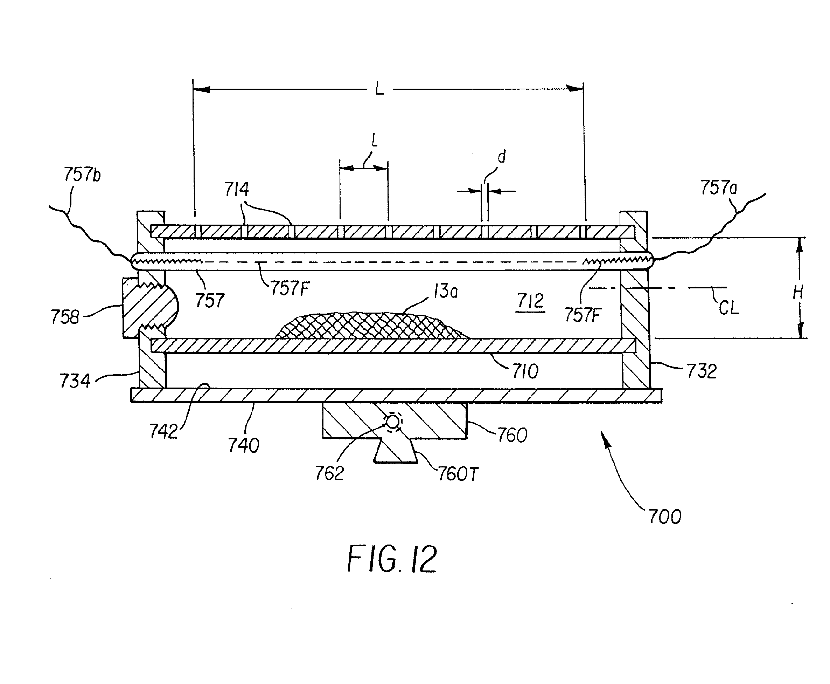

FIG. 12 is a schematic longitudinal section view of another embodiment of a tubular thermal physical vapor deposition source assembly in which a cavity of a tubular source is heatable by a heat lamp disposed within the cavity, in accordance with an aspect of the present invention;

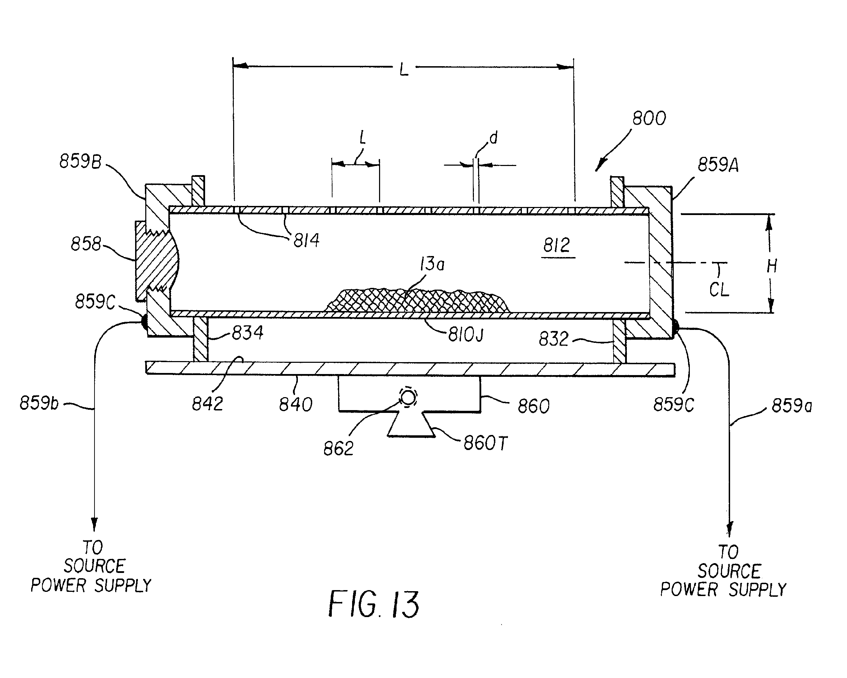

FIG. 13 is a schematic longitudinal section view of another embodiment of a tubular thermal physical vapor deposition source assembly in which a tubular source is directly heatable by passing electrical current from one end to another end of the tubular source, in accordance with an aspect of the present invention;

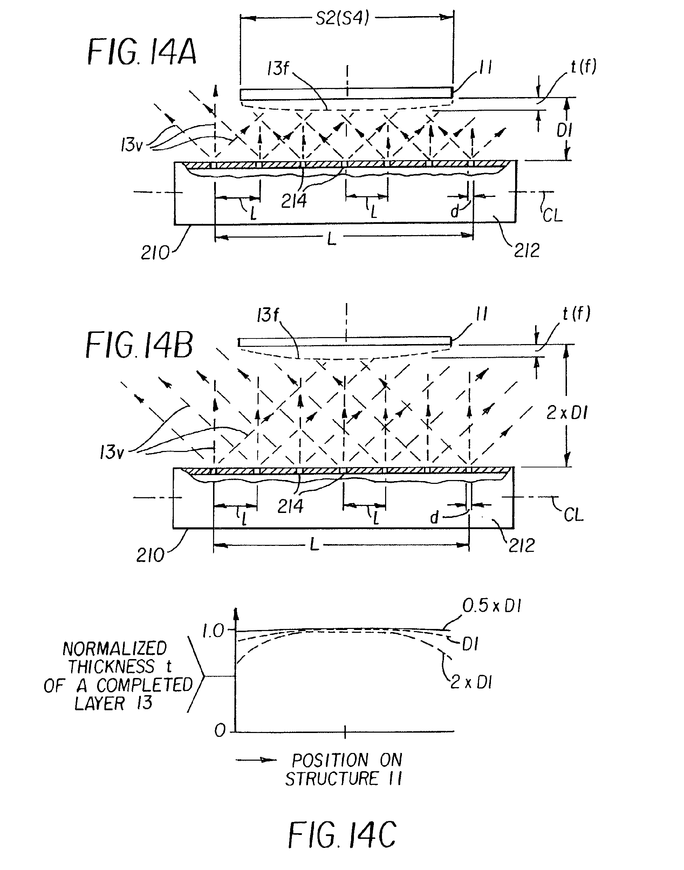

FIGS. 14A-14C show schematically a relationship between a thickness profile across a substrate or structure and a tubular source spacing from the substrate or structure, wherein:
FIG. 14A depicts a spacing D1;
FIG. 14B depicts a spacing 2xD1; and
FIG. 14C shows the thickness profiles of a completed organic hole-transporting layer across the structure for three spacings between a tubular source and the structure during vapor deposition;

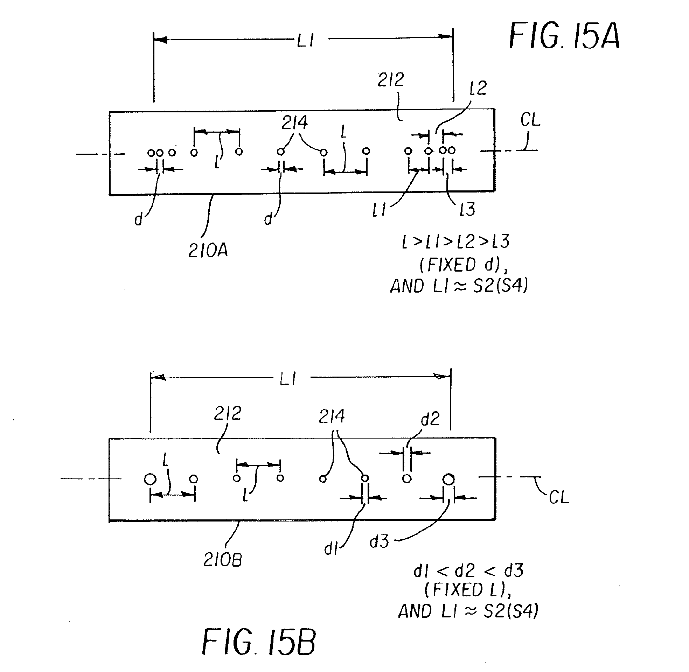

FIGS. 15A and 15B show top views of simplified models of a tubular source in which openings extending into a cavity of the source are modified near end portions of a line of openings to provide improved uniformity of thickness of a vapor-deposited organic layer across a structure, in accordance with an aspect of the present invention;
FIG. 15A shows openings having a fixed diameter along the line of openings and a progressively smaller center-to-center distance between openings near end portions of the line of openings; and
FIG. 15B shows openings having a fixed center-to-center distance between openings along the line of openings and a progressively increasing diameter of openings near end portions of the line of openings; and

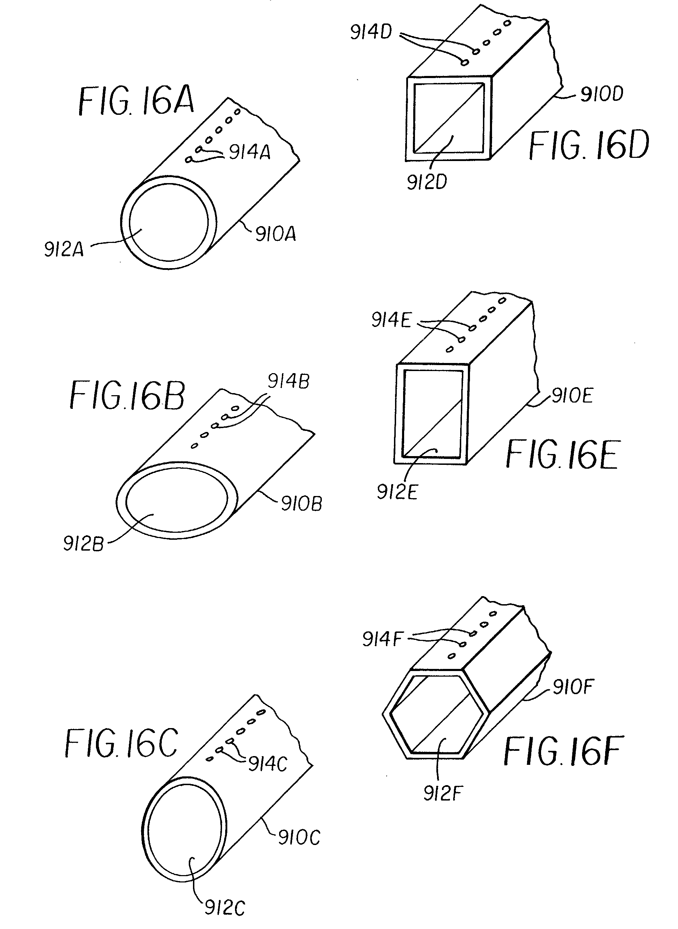

FIGS. 16A-16F depict partial perspective views of various designs of tubular vapor deposition sources useful in the practice of the invention,
   wherein
FIG. 16A shows a tubular source having a circular cross-section;
FIG. 16B shows a tubular source having a horizontal ellipsoidal cross-section;
FIG. 16C shows a tubular source having a vertical ellipsoidal cross-section;
FIG. 16D shows a tubular source having a square cross-section;
FIG. 16E shows a tubular source having a vertical rectangular cross-section; and
FIG. 16F shows a tubular source having a hexagonal cross-section.

The drawings are necessarily of a schematic nature since layer thickness dimensions of organic light-emitting devices (OLEDs) are frequently in the sub-micrometer ranges, while features representing lateral device dimensions can be in a range of 50-500 millimeter. Also, the various embodiments of a tubular vapor deposition source are schematic representations in that the openings are difficult to scale in size and in center-to-center spacing. Accordingly, the drawings are scaled for ease of visualization rather than for dimensional accuracy.

The term "substrate" denotes a light-transmissive support having a plurality of laterally spaced first electrodes (anodes) preformed thereon, such substrate being a precursor of a passive matrix OLED. The term "structure" is used to describe the substrate once it has received a portion of a vapor-deposited organic layer, and to denote an active matrix array as a distinction over a passive matrix precursor.

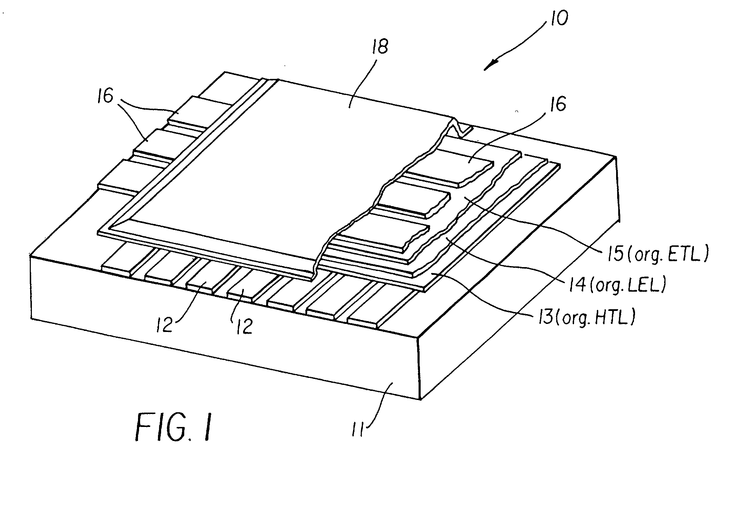

Turning to FIG. 1, a schematic perspective view of a passive matrix organic light-emitting device (OLED) 10 is shown having partially peeled-back elements to reveal various layers.

A light-transmissive substrate 11 has formed thereon a plurality of laterally spaced first electrodes 12 (also referred to as anodes). An organic hole-transporting layer (HTL) 13, an organic light-emitting layer (LEL) 14, and an organic electron-transporting layer (ETL) 15 are formed in sequence by a physical vapor deposition, as will be described in more detail hereinafter. A plurality of laterally spaced second electrodes 16 (also referred to as cathodes) are formed over the organic electron-transporting layer 15, and in a direction substantially perpendicular to the first electrodes 12. An encapsulation or cover 18 seals environmentally sensitive portions of the structure, thereby providing a completed OLED 10.

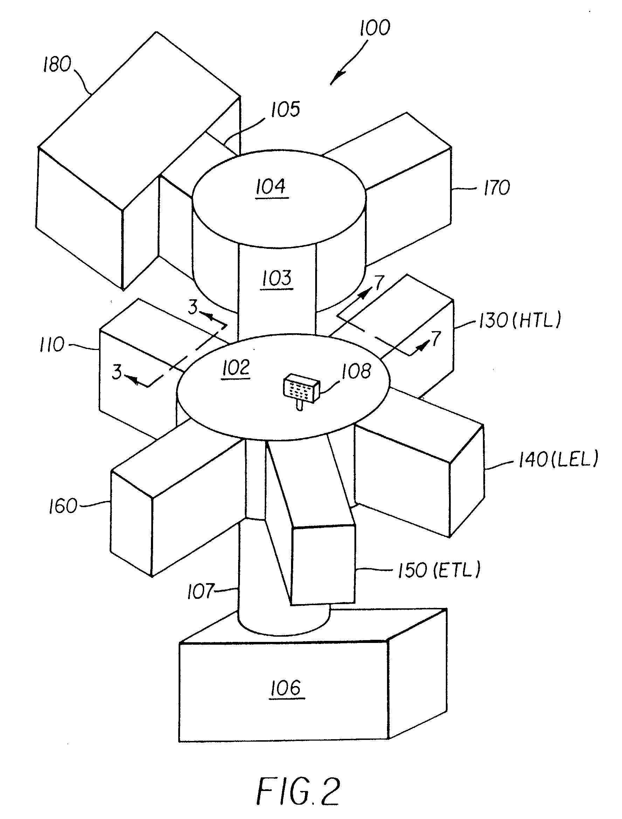

Turning to FIG. 2, a schematic perspective view of a apparatus 100 is shown which is suitable for manufacture of a relatively large number of organic light-emitting devices using automated or robotic means (not shown) for transporting or transferring substrates or structures among a plurality of stations extending from a buffer hub 102 and from a transfer hub 104. A vacuum pump 106 via a pumping port 107 provides reduced pressure within the hubs 102, 104, and within each of the stations extending from these hubs. A pressure gauge 108 indicates the reduced pressure within the system 100. The pressure can be in a range from about 10⁻³ to 10⁻⁶ Torr.

The stations include a load station 110 for providing a load of substrates or structures, a vapor deposition station 130 dedicated to forming organic hole-transporting layers (HTL), a vapor deposition station 140 dedicated to forming organic light-emitting layers (LEL), a vapor deposition station 150 dedicated to forming organic electron-transporting layers (ETL), a vapor deposition station 160 dedicated to forming the plurality of second electrodes (cathodes), an unload station 103 for transferring structures from the buffer hub 102 to the transfer hub 104 which, in turn, provides a storage station 170, and an encapsulation station 180 connected to the hub 104 via a connector port 105. Each of these stations has an open port extending into the hubs 102 and 104, respectively, and each station has a vacuum-sealed access port (not shown) to provide access to a station for cleaning, replenishing materials, and for replacement or repair of parts. Each station includes a housing which defines a chamber.

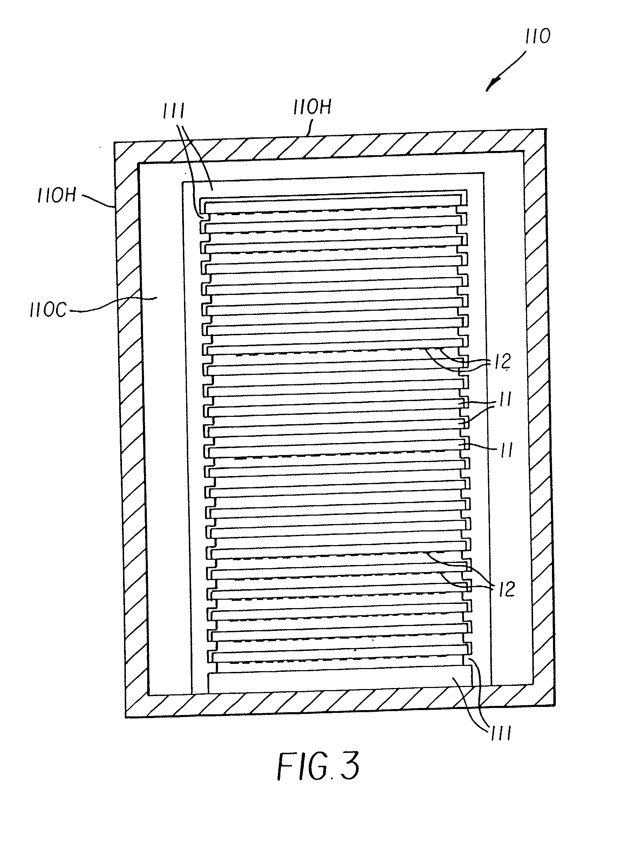

FIG. 3 is a schematic section view of the load station 110, taken along section lines 3-3 of FIG. 2. The load station 110 has a housing 110H which defines a chamber 110C. Within the chamber is positioned a carrier 111 designed to carry a plurality of substrates 11 having preformed first electrodes 12 (see FIG. 1). An alternative carrier 111 can be provided for supporting a plurality of active matrix structures. Carriers 111 can also be provided in the unload station 103 and in the storage station 170.

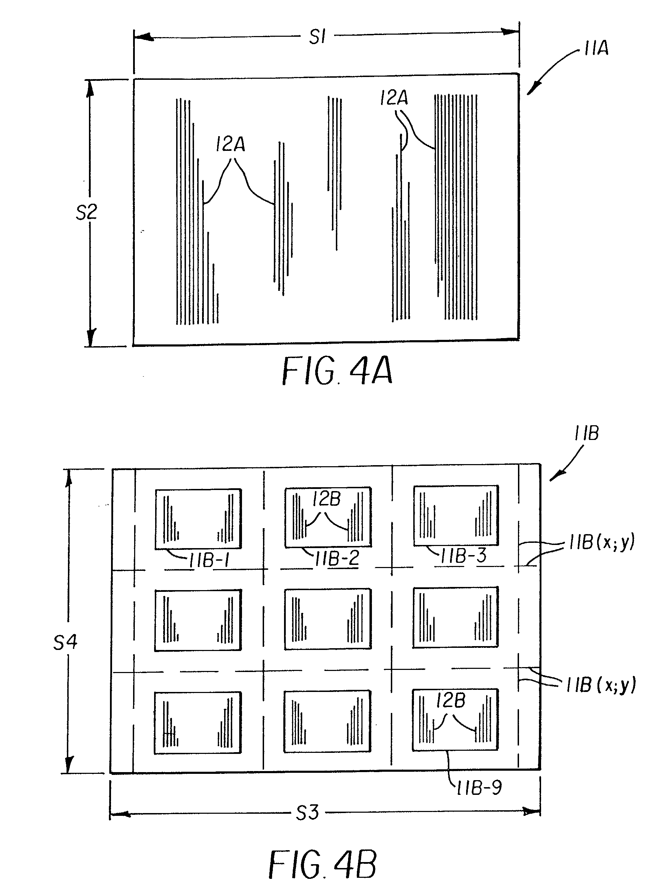

Turning to FIGS. 4A and 4B, a single OLED device substrate 11A and a multiple-device substrate 11B, respectively, are shown in schematic plan views. The single OLED device substrate 11A has disposed on a surface thereof a plurality of first electrodes or anodes 12A which are depicted for illustrative purposes as extending parallel with a width dimension S2, or normal to a length dimension S1 of the substrate.

The multiple-device substrate 11B is shown for illustrative purposes as having nine identical spaced-apart device substrates denoted 11B-1 (a first device substrate), 11B-2, 11B-3, through 11B-9 (a ninth device substrate). Scribe-and-break lines 11B (x;y) are shown in dashed outline. Upon completed manufacture, for example in the OLED apparatus 100 of FIG. 2, multiple OLEDs are provided by scribing and breaking the substrate along the lines 11B (x;y). Each of the device substrates 11B-1 through 11B-9 has a plurality of first electrodes or anodes 12B which extend in a direction parallel with a width dimension S4 of the multiple-device substrate 11B, or normal to a length dimension S3 thereof.

The length dimensions can be chosen at any dimension. The OLED apparatus 100 can be adapted to manipulate, position, provide vapor-deposited layers over, and provide encapsulation for devices, formed on substrates or structures with the chosen dimension.

The width dimensions S2 and S4 are depicted here to suggest a rectangular outline of the substrates 11A and 11B. It will be appreciated that square-shaped substrates can be selected as well.

The substrates 11A and 11B are typically glass substrates having indium-tin-oxide (ITO) first electrodes or anodes 12A and 12B, respectively, preformed over a substrate surface.

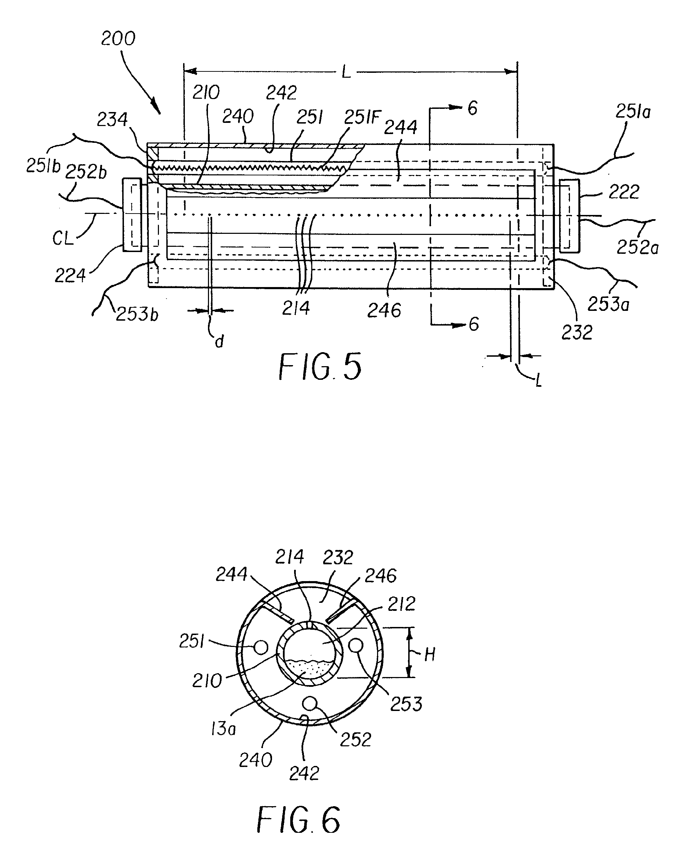

Turning to FIG. 5 and FIG. 6, FIG. 5 shows a partially sectioned top view of a tubular thermal physical vapor deposition source assembly 200, and FIG. 6 is a schematic section view of the assembly taken along the section lines 6-6 of FIG. 5. The assembly 200 includes a cylindrical tubular source 210, a heat shield 240 spaced from the source by heat shield supports 232 and 234, and heat lamps 251, 252, and 253 extending axially between the tubular source 210 and the heat shield 240, with the heat lamps held in position by the heat shield supports 232 and 234. The tubular source can also be called a linear vapor deposition source. The heat shield supports 232 and 234 are preferably constructed of a thermally and electrically insulative material such as, for example, a ceramic material or quartz. These heat shield supports are fixedly attached proximate the axial ends of the tubular source. End caps 222 and 224 sealingly engage axial ends of the cylindrical tubular source 210 so that the sealed tubular source defines a cavity 212. Sealing engagement between the tubular source 210 and the end caps 222 and 224 is provided by mating threads (not shown), bayonet-type fastening (not shown) or by other removable sealing means, so that access is provided to the cavity for replenishment of organic material therein and for cleaning of the cavity 212, if required. The cavity 212 has a height dimension H (an inside diameter of the tubular source 210 when it has a cylindrical cross-section), and the cavity contains a charge of organic hole-transporting material 13a which was introduced by removing one or both of the end caps 222 and/or 224.

A line of openings 214 formed in the tubular source 210 extend into the cavity 212. The line of openings has a length dimension L (taken from the leading edge of the first opening in the line to the trailing edge of the last opening in the line) which is at least three times greater than the height dimension of the cavity 212. The openings 214 are circular openings having a diameter d and a center-to-center spacing or pitch 1.

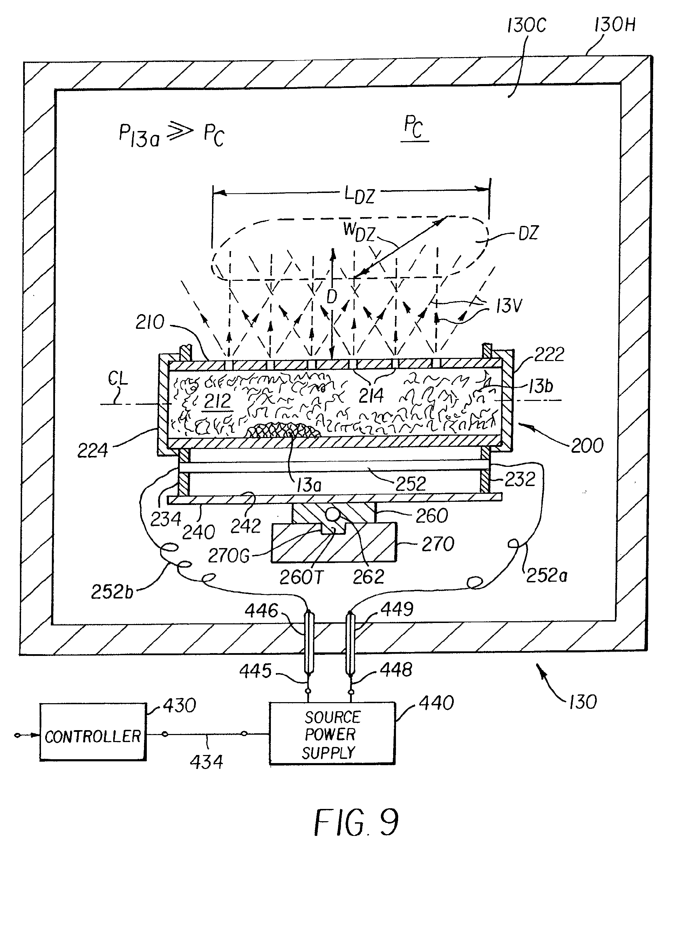

The heat lamps 251, 252, and 253 are linear heat lamps having a central filament such as, for example, the filament 251F shown in FIG. 5. Such heat lamps are commercially available from numerous suppliers and are referred to as quartz tungsten halogen lamps, halogen quartz lamps, or tubular quartz halogen lamps. Each of the heat lamps has two lamp leads for a connection to a power source. For example, the heat lamp 251 has lamp leads 251a and 251b, the heat lamp 252 has lamp leads 252a and 252b, and the heat lamp 253 has lamps leads 253a and 253b. These lamp leads allow for electrical connection of the three lamps either in parallel or in series. When energized, the heat lamps heat the cylindrical tubular source 210 so that a portion of the organic material 13a will vaporize to form a vapor of organic material which uniformly spreads throughout the cavity 212 and which exits the cavity through the line of openings 214. This will be described in more detail with reference to FIG. 9.

The heat shield 240 can be constructed of a metal such as, for example, aluminum having a heat-reflective surface 242 facing the heat lamps. Heat shield terminations 244 and 246 are shaped so that the line of openings 214 is revealed.

The assembly 200 is substantially symmetrically disposed about a center line CL. While three heat lamps are shown for illustrative purposes, it will be understood that fewer or more heat lamps can be used. The cylindrical tubular source 210 is preferably constructed of a metal having high thermal conductivity such as, for example, copper.

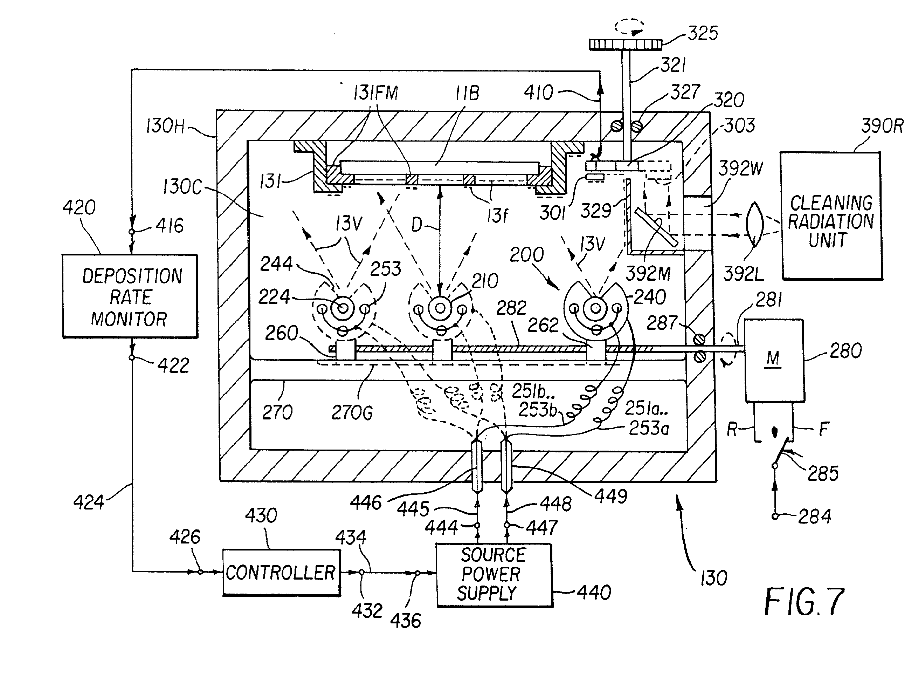

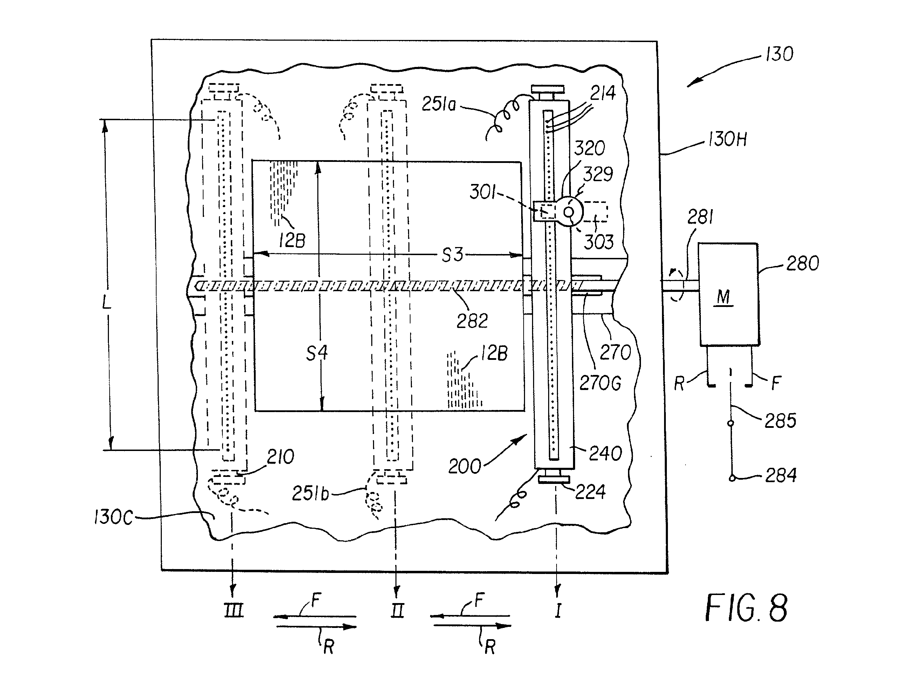

The application of the tubular thermal physical vapor deposition source assembly 200 of FIGS. 5 and 6 in the organic HTL vapor deposition station 130 of FIG. 2 may be better understood by viewing FIG. 7 in conjunction with FIG. 8, wherein
FIG. 7 is a schematic section view of the HTL station 130, taken along the section lines 7-7 of FIG. 2, and showing the substrate 11B of FIG. 4B and the assembly 200 disposed within a chamber 130C defined by a housing 130H of the station 130, and
FIG. 8 is a schematic top view of a portion of the chamber 130C, and indicating forward motion "F" and reverse motion "R" of the assembly 200 from and to a "parked" position "I".

With the tubular source assembly 200 being initially in the "parked" position indicated in solid outline, a substrate 11B (or a structure 11) is inserted into a frame mask 131FM supported by a holder 131, by robotic means from the buffer hub 102 of the OLED apparatus 100 of FIG. 2.

The tubular source 210 is operative and controlled as detailed hereinafter, so that vapor 13v of organic hole-transporting material exits the cavity 212 through the line of openings 214 while the tubular source assembly remains in the "parked" position. In this position, the vapor 13v forms a deposit on a sensor 301 which is disposed on a rotatable sensor support 320, and which is rotatable via a spindle 321 having a seal 327 in the housing 130H, the spindle 321 attached to a rotator 325. The sensor 301, depicted here as a crystal mass-sensor, provides a signal corresponding to a mass of deposited material to an input terminal 416 of a deposition rate monitor 420 via a lead 410. The deposition rate monitor can be adjusted to provide a selected deposition rate of organic hole-transporting material on the sensor 301. A signal corresponding to the selected deposition rate is provided at an output terminal 422 of the deposition rate monitor and is applied to an input terminal 426 of a controller or amplifier 430 via a lead 424. A lead 434 connects an output terminal 432 of the controller 430 with an input terminal 436 of a source power supply 440.

One output terminal 444 of the source power supply 440 is connected to a feedthrough 446 via lead 445, and another output terminal 447 is connected to a feedthrough 449 via a lead 448.

Lamp leads 251a, 252a, and 253a (see FIGS. 5 and 6) are shown connected to the feedthrough 449, and lamp leads 251b, 252b, and 253b are connected to the feedthrough 446.

For purposes of clarity of the drawings, the heat lamps 251, 252, and 253 are shown here in a parallel connection. It will be appreciated that the heat lamps can be electrically connected in series.

By adjusting the deposition rate monitor 420 to provide a selected deposition rate, the source power supply 440 will provide a corresponding electrical power to the heat lamps which, in turn, causes the organic hole-transporting material 13a in the cavity 212 of the tubular source 210 (see FIG. 6) to vaporize in the cavity and to exit the cavity as vapor 13v through the line of openings 214 for forming a deposit on the sensor 301 at the selected rate.

The sensor 301 can be cleaned by rotating the sensor into a cleaning position 303, shown in dashed outline, via the rotatable sensor support 320. The cleaning position 303 is shielded by a shield 329 from the vapor 13v, and cleaning, that is removal in whole or in part of organic material formed on the sensor 301, is provided by radiation directed at the sensor in the cleaning position from a cleaning radiation unit 390R via a lens or lenses 392L, a radiation-transmissive window 392W disposed in the housing 130H, and a mirror 392M.

Upon achievement of a desired vapor deposition rate, as measured by the sensor 301 in the form of a mass change of organic material condensing thereon from the vapors 13v, the source assembly 200 is moved linearly with respect to the substrate 11B from the "parked" position (indicated at "I" in FIG. 8) in a forward direction "F" past an intermediate position (indicated at "II" in FIG. 8), and shown in dashed outline, to a final or terminal position (indicated at "III" in FIG. 8) at a location beyond an edge of the substrate 11B (an edge shown to the left of the substrate in FIGS. 7 and 8).

The source assembly 200 is then moved, translated, or scanned linearly from the position "III" in a reverse direction "R" past an intermediate position to return to the "parked" position "I" in which the previously adjusted and controlled vapor deposition rate can be verified or can be readjusted if required.

The linear forward ("F") and reverse ("R") motion of the source assembly 200 with respect to the substrate are provided by a lead screw 282 which matingly engages a threaded bore 262 formed in a glide bracket 260. The glide bracket 260 is attached to the heat shield 240, and has a tongue 260T (see FIGS. 9 and 12) which slideably engages a groove 270G formed in a glide support 270. The glide support 270 is shown attached to an interior wall of the housing 130 for illustrative purposes only.

The lead screw 282 includes a lead screw shaft 281 which extends through the housing 130H via a shaft seal 287 to a motor 280 for rotating the lead screw shaft 281. A forward direction "F" and a reverse direction "R" of the rotation of the motor 280 is selectable by a switch 285 which provides a signal at an input terminal 284 to actuate either forward rotation "F" or reverse rotation "R" of the motor, and to provide corresponding forward and reverse linear motions of the tubular vapor deposition assembly 200 within the chamber 130C.

The cleaning radiation unit 390R, the deposition rate monitor 420, and the controller 430 and source power supply 440 have been omitted from the drawing of FIG. 8.

The line of openings 214 are spaced from the substrate 11B (or from a substrate 11A or a structure 11) by a predetermined distance D which is in a preferred range from 2-10 centimeter (cm) to provide a uniform layer 13f of organic hole-transporting material being formed over the substrate following a forward ("F") translation of the source assembly 200 with respect to the substrate, and to provide a completed organic hole-transporting layer 13 (see FIG. 1) on the substrate following the reverse ("R") linear motion, translation, or scan of the source assembly on its return to the "parked" position.

As schematically shown in FIG. 8, a length dimension L of the line of openings 214 is greater than a width dimension S4 of the substrate 11B (depicted without the holder 131 and frame mask 131FM to preserve clarity of the drawing) to ensure that a uniform coating thickness of a layer or deposit 13f being formed, and of a completed layer 13 can be achieved across the width dimension S4 of the substrate. Additionally, the line of openings 214 in the "parked" position I of the source assembly 200 is positioned sufficiently to the right of a right edge of the substrate 11B so that the substrate does not receive an organic deposit in this position, and the line of openings is positioned to the left of a left edge of the substrate in the terminal or final position III of the motion of the source assembly so that the substrate continues to receive a fractional deposit of organic hole-transporting material just prior to actuation of the reverse linear motion "R" of the assembly 200 with respect to the substrate.

Although not shown in the drawings, it will be appreciated that relative motion between a tubular thermal physical vapor deposition source assembly and a substrate or structure can be provided by linear motion of the frame mask 131FM within the holder 131 with respect to a fixedly positioned source assembly 200 which would, in this case, be rotated 90° compared to the source orientations shown in FIGS. 7 and 8.

FIG. 9 is a schematic longitudinal section view of the vapor deposition source assembly 200 of FIG. 5 which is shown operative in the HTL vapor deposition station 130 of FIG. 2. Only one heat lamp 252 is shown, with lamp leads 252a and 252b connected to the source power supply 440 via the feedthroughs 449 and 446, respectively.

The glide bracket 260 is attached to the heat shield 240 and has a threaded bore 262 (for engaging the lead screw 282 of FIGS. 7 and 8) and includes a tongue 260T. The tongue 260T slideably engages the groove 270G formed in the glide support 270.

The heat lamps (251, 252, and 253 shown in FIG. 6) receive sufficient electrical power from the source power supply 440 to heat the tubular source 210 so that the organic hole-transporting material 13a disposed in the cavity 212 vaporizes by sublimation or by evaporation so that vapor 13b is spread or distributed uniformly throughout the cavity 212. This is achieved because a vapor pressure P₁₃ₐ of the organic hole-transporting material 13a is significantly higher than the reduced pressure P_{c} in the chamber 130C. For example, the pressure P_{c} in the chamber may be reduced to 10⁻⁵ Torr, while the vapor pressure P₁₃ₐ of the organic material may be about 10⁻² Torr at a temp of about 300°C prevailing in the cavity 212.

The pressure of the vapor 13b in the cavity reaches equilibrium value which is determined by a flux of vapor 13v which exits the cavity 212 through the openings 214 to be projected into the chamber 130C held at the pressure P_{c}.

At the distance D from the line of openings 214, a deposition zone DZ can be defined by a length dimension L_{DZ} and a width dimension W_{DZ}. Within the plane of the deposition zone DZ the flux of vapors 13v is substantially uniform, and a substrate or structure is preferably positioned within the deposition zone.

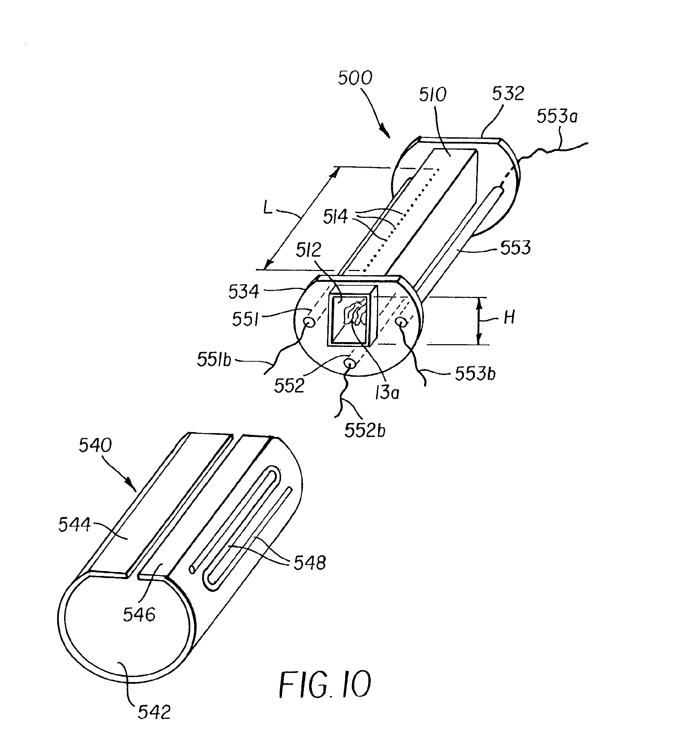

Turning to FIG. 10, a tubular thermal physical vapor deposition source assembly 500 is shown in a schematic exploded perspective view. A rectangular tubular source 510 is heatable by heat lamps 551, 552, and 553 so as to vaporize organic hole-transporting material 13a disposed in the cavity 512 and to provide vapor exit from the cavity through the line of openings 514 (end caps have been omitted from the drawing of FIG. 10). The height dimension H for this tubular source is shown in FIG. 10.

The heat shield 540 includes a heat shield cooling coil 548 disposed over at least a portion of the exterior surface of the heat shield 540. The heat shield cooling coil 548 can be used to flow a cooling fluid or a cooling gas through the coil so that the heat shield 540 can remain relatively cool during operation of the tubular source 500.

Numeral designations of like or similar parts of the assembly 500 correspond to designations of parts of the previously described assembly 200. For example, the heat lamps 551-553 correspond to the heat lamps 251-253 of FIGS. 5 and 6, and the heat-reflective surface 542 of the heat shield 540 corresponds to the heat-reflective surface 242 of the heat shield 240 of FIGS. 5 and 6.

FIGS. 11A and 11B are schematic top views of a tubular thermal physical vapor deposition source assembly 600 in which a tubular source 610 is heatable by a spiral heating element 655 (FIG. 11A) or by a serpentine element 656 (FIG. 11B).

In these embodiments, the tubular source 610 is constructed of a material having a relatively high thermal conductivity and being electrically substantially insulative. Boron nitride (BN) is a material useful in constructing a tubular source 610 which has a cavity 612 heatable by heating elements disposed around an exterior surface of the tubular source 610. Heating element leads 655a and 655b extend from the spiral heating element 655, and heating element leads 656a and 656b extend from the serpentine heating element 656.

Numerical designations of like or similar parts of the assembly 600 correspond to designations of parts of the previously described assembly 200. For example, the openings 614 correspond to the openings 214 described with reference to FIGS. 5 and 6.

Turning to FIG. 12, a schematic longitudinal section view of a tubular thermal physical vapor deposition source assembly 700 is shown. A heat lamp 757 having a filament 757F is disposed inside the cavity 712 at a position upperwardly from a center line CL in a direction towards the openings 714 of the tubular source 710. The heat lamp 757 is supported by heat shield supports 732 and 734 which also function as end caps for sealing the axial ends of the tubular source 710. Lamp leads 757a and 757b extend from the heat lamp 757. A cavity seal 758 can be removed to provide access to the cavity 712 for replenishing the organic hole-transporting material 13a in the cavity when required. The glide bracket 760 attached to the heat shield 740 is depicted here with a dovetail tongue 760T.

Numerical designations of like or similar parts of the assembly 700 correspond to designations of parts of the previously described assembly 200. For example, the openings 714 correspond to the openings 214 of the assembly 200 described with reference to FIGS. 5 and 6.

Turning to FIG. 13, a schematic longitudinal section view of a thermal physical vapor deposition source assembly 800 is shown in which a tubular source 810J is constructed of a material having a relatively low electrical conductivity such as, for example, tantalum or molybdenum to provide for direct heating (Joule heating) of the source 810J.

Electrically conductive end caps 859A and 859B are in electrical contact with axial ends of the tubular source 810J. End cap leads 859a and 859b are connected to corresponding end caps by an end cap connector 859c, and these leads are connected to a source power supply (not shown).

A cavity seal 858 is shown disposed in the end caps 859B, and provides access to the cavity 812 when required.

Numerical designations of like or similar parts of the assembly 800 correspond to designations of parts of the previously described assembly 200. For example, the heat shield supports 832 and 834 correspond to the heat shield supports 232 and 234 described with reference to the assembly 200 to FIGS. 5 and 6.

FIGS. 14A to 14C show schematically a relationship between a thickness profile across a substrate or structure and a tubular source spacing from the substrate or structure, wherein
FIG. 14A depicts a spacing D1,
FIG. 14B depicts a spacing of 2xD1, and
FIG. 14C shows the thickness profiles of a completed organic hole-transporting layer 13 across the structure for the spacing D1, 2xD1, and for a spacing 0.5xD1 (not shown in FIGS. 14A and 14B).

The housing 130H defining the chamber 130C (see FIGS. 7, 8, and 9), as well as means for heating the tubular source 210, have been omitted from the drawings of FIGS. 14A and 14B. The substrate or structure 11 is shown with the dimensions S2 or S4, corresponding to the width dimensions of the substrates of FIG. 4A and FIG. 4B, respectively.

The configurations of the tubular source 210 and openings 214 with respect to the substrate shown in FIGS. 14A and 14B are similar to the configurations depicted in FIGS. 8 and 9.

The diameter d of the openings 214, the center-to-center spacing or pitch 1 between openings, and the length dimension L of the line of openings are identical in FIGS. 14A and 14B, with L>S2 (S4).

An organic hole-transporting layer 13f being formed on the substrate or structure 11 has a thickness t(f) over a central portion of the substrate or structure. The thickness t(f) decreases from the central-portion value towards the edge portions of the structure 11 because vapor streams 13v emanating from openings 214 located near end portions of the line of openings do not contribute to providing a uniform vapor flux directed towards the structure 11.

For illustrative purposes, such thickness decrease of the layer 13f towards the edge portions has been exaggerated. However, it will be evident from a comparison of the layers 13f being formed at the spacing D1 (FIG. 14A) and at the spacing 2xD1 (FIG. 14B) that the layer 13f formed at the larger source-to-substrate spacing has a more restricted central portion of thickness t(f) and, accordingly, a more pronounced decrease of thickness towards edge portions of the substrate or structure 11.

This effect is summarized in FIG. 14C, which shows thickness profiles (expressed in terms of normalized thickness) of a completed organic hole-transporting layer 13 prepared at three different spacings between the openings 214 and the structure 11.

FIGS. 15A and 15B show top views of simplified models of a tubular source in which openings 214 extending into the cavity 212 of the tubular source 210A (FIG. 15A) and 210B (FIG. 15B) are modified near end portions of a line of openings which has a length dimension L1 so that an improved uniformity of thickness of a vapor-deposited organic layer can be achieved across a structure.

In FIG. 15A, all openings 214 have a diameter d. Over a central portion of the source 210A, the openings have a center-to-center spacing 1. Near end portions of the line of openings, the center-to-center distance between openings decreases progressively. For example, the distance 1 is larger than the distance 11, which is larger than 12, and 12 is larger than 13.

This configuration of openings 214 enhances the vapor flux of vapors 13v near the end portions of the line of openings, and the length dimension L1 of the line of openings can approximate the dimension of the structure S2 (S4) compared with the length dimension L as shown in FIGS. 14A and 14B. Thus, the configuration of openings 214 of the source 210A will provide an improved uniformity of thickness of an organic layer across a structure.

In FIG. 15B, all openings 214 of the tubular source 210B have a center-to-center distance 1. Over a central portion of the line of openings, the openings have a diameter d1. Near end portions of the line of openings the diameter of the openings increases progressively. For example, the diameter d1 is smaller than the diameter d2, which is smaller than the diameter d3 of these openings.

This configuration of openings also enhances the vapor flux of vapors 13v near the end portions, and the length dimension L1 can approximate the dimension of the structure, S2 (S4) compared with the length dimension L of the line of openings shown in FIGS. 14A and 14B. Thus, this configuration of openings provides an improved uniformity of thickness of an organic layer across a structure.

FIGS. 16A-16F depict partial perspective views of various designs of tubular vapor deposition sources useful in the practice of the invention,
wherein:
FIG. 16A shows a tubular source 910A having a circular cross-section and including a cavity 912A and a line of openings 914A extending into the cavity; FIG. 16B shows a tubular source 910B having a horizontal ellipsoidal cross-section and including a cavity 912B and a line of openings 914B extending into the cavity; FIG. 16C shows a tubular source 910C having a vertical ellipsoidal cross-section and including a cavity 912C and a line of openings 914C extending into the cavity; FIG. 16D shows a tubular source 910D having a square cross-section and including a cavity 912D and a line of openings 914D extending into the cavity; FIG. 16E shows a tubular source having a vertical rectangular cross-section and including a cavity 912E and a line of openings 914E extending into the cavity; and FIG. 16F shows a tubular source 91 OF having a hexagonal cross-section and including a cavity 912F and openings 914F extending into the cavity.

It will be appreciated that an embodiment of a tubular thermal physical vapor deposition source assembly can be incorporated into each one of the vapor deposition stations 130, 140, and 150 of the OLED apparatus 100 shown in FIG. 2 to provide corresponding organic layers on a structure.

Other features of the invention are included below.

The apparatus wherein the line of openings formed in the source include a plurality of circular openings each having a diameter d and a center-to-center spacing or pitch 1, and the line of openings is spaced from the structure by a predetermined distance.

The apparatus wherein the line of openings formed in the source include a central portion of circular openings having a diameter d and a center-to-center spacing or pitch 1, and end portions of circular openings having the diameter d and a progressively decreasing center-to-center spacing or a progressively increasing pitch 11, 12, and 13, respectively, wherein 1>11>12>13, so that a uniform desired thickness of an organic layer is deposited on the structure.

The apparatus wherein the line of openings formed in the source include a central portion of circular openings having a diameter d1 and a center-to-center spacing or pitch 1, and end portions of circular openings having the pitch 1 and a progressively increasing diameter d1, d2, and d3, respectively, wherein d1<d2<d3, so that a uniform desired thickness of an organic layer is deposited on the structure.

The apparatus wherein the relative motion means includes a rotatable lead screw which engages a threaded bore disposed in a glide bracket being fixedly attached to a portion of the heat shield so that the tubular vapor deposition source can be slideably translated along a glide support disposed within the chamber.

The apparatus wherein the relative motion means includes means for continuously translating the tubular vapor deposition source from a parked position in a first or forward direction to provide a partially formed organic layer across the structure, and means for continuously translating the tubular vapor deposition source in a second or reverse direction for return to the parked position to provide a completely formed organic layer across the structure.

The apparatus further includes sensing means disposed in the chamber within the deposition zone of the tubular vapor deposition source and oriented with respect to the parked position of the source for sensing a rate at which the vapor of organic material is provided by the source through the line of openings therein, the sensing means providing an electrical signal which corresponds to such sensed rate, and the electrical signal being used to control the means for controllably heating the tubular vapor deposition source.

The apparatus further including means for cleaning the sensing means by removing in part or in full organic material vapor-deposited on the sensing means so that such sensing means can be reused without disruption of vapor deposition.

The apparatus further including means for cooling the heat shield.

A tubular physical vapor deposition source for use in a pressure reduced chamber to deposit an organic layer on a structure which will provide an OLED, comprising:
a) a housing defining a cavity adapted for receiving organic material to be vaporized therein, the housing having a line of openings extending into the cavity, such line of openings having a length dimension which is at least three times greater than a height dimension of the cavity, and the line of openings depositing organic material into a deposition zone onto the structure; and
b) means for controllably heating the tubular vapor deposition source to cause the organic material to form a vapor at a controlled rate, the vapor being distributed throughout the cavity and exiting the cavity through the line of openings at a controlled rate.

The source further including a heat shield, the heat shield defining another opening over the line of openings.

The source further including a metal having a relatively high thermal conductivity, and the cavity has a circular cross-section, an ellipsoidal cross-section, or a polygonal cross-section.

The source wherein the means for controllably heating the tubular vapor deposition source includes a plurality of heat lamps spacedly disposed between the tubular vapor deposition source and the heat shield, the heat lamps being electrically connected in parallel or in series and being heated by electrical power provided by a controllable source power supply.

The source wherein the means for controllably heating the tubular vapor deposition source includes at least one heat lamp disposed within the cavity, the at least one heat lamp being heated by electrical power provided by a controllable source power supply.

## Claims

1. Apparatus for vapor-depositing an organic layer onto a structure which will provide part of an organic light-emitting device, comprising:
a) a housing defining a chamber and a pump connected to the chamber for producing a reduced pressure therein, the structure being positioned in the chamber in a deposition zone;
b) a tubular thermal physical vapor deposition source disposed in the chamber and spaced from the structure, the source defining a cavity for receiving organic material to be vaporized, and the organic material having a vapor pressure which is substantially greater than the reduced pressure in the chamber;
c) the tubular physical vapor deposition source defining a line of openings extending into the cavity, the line of openings being arranged so that vaporized organic material is deposited into the deposition zone onto the structure;
d) means for controllably heating the tubular vapor deposition source to cause the organic material to form a vapor at a controlled rate, the vapor being distributed throughout the cavity and exiting the cavity through the line of openings at a controlled rate; and
e) means for providing relative linear motion between the tubular vapor deposition source and the structure so that the vapor of organic material in the deposition zone causes formation of a uniformly thick vapor-deposited organic layer on the structure.

2. Apparatus for vapor-depositing an organic layer onto a structure which will provide part of an organic light-emitting device, comprising:
a) a housing defining a chamber and a pump connected to the chamber for producing a reduced pressure therein, the structure being positioned in the chamber in a deposition zone;
b) a tubular thermal physical vapor deposition source disposed in the chamber and spaced from the structure, the source defining a cavity for receiving organic material to be vaporized, the cavity having a length dimension and a height dimension, and the organic material having a vapor pressure which is substantially greater than the reduced pressure in the chamber;
c) the tubular physical vapor deposition source defining a line of openings extending into the cavity, the line of openings having a length dimension which is at least three times greater than the height dimension of the cavity, and the line of openings depositing organic material into the deposition zone onto the structure;
d) means for controllably heating the tubular vapor deposition source to cause the organic material to form a vapor at a controlled rate, the vapor being distributed throughout the cavity and exiting the cavity through the line of openings at a controlled rate; and
e) means for providing relative linear motion between the tubular vapor deposition source and the structure so that the vapor of organic material in the deposition zone causes formation of a uniformly thick vapor-deposited organic layer on the structure.

3. The apparatus of claim 2 further including a heat shield, the heat shield defining another opening over the line of openings formed in the tubular vapor deposition source.

4. The apparatus of claim 3 wherein the tubular vapor deposition source includes a metal having a relatively high thermal conductivity, and the source having a circular cross-section, an ellipsoidal cross-section, or a polygonal cross-section.

5. The apparatus of claim 3 wherein the means for controllably heating the tubular vapor deposition source includes a plurality of heat lamp spacedly disposed between the tubular vapor deposition source and the heat shield, the heat lamps being electrically connected in parallel or in series and being heated by electrical power provided by a controllable source power supply.

6. The apparatus of claim 2 wherein the means for controllably heating the tubular vapor deposition source includes at least one heat lamp disposed within the cavity, the at least one heat lamp being heated by electrical power provided by a controllable source power supply.

7. The apparatus of claim 2 wherein the tubular vapor deposition source has a circular cross-section and includes a material having a relatively high thermal conductivity and a substantially low electrical conductivity.

8. The apparatus of claim 7 wherein the means for controllably heating the tubular vapor deposition source includes at least one heating element disposed about an outer surface of the tubular vapor deposition source, the at least one heating element being heated by electrical power provided by a controllable source power supply.

9. The apparatus of claim 2 wherein the tubular vapor deposition source includes material having a relatively low electrical conductivity, and the source has a circular cross-section, an ellipsoidal cross-section, or a polygonal cross-section.

10. The apparatus of claim 9 wherein the means for controllably heating the tubular vapor deposition source includes means for direct heating of the tubular vapor deposition source by applying a voltage between axial terminations of the tubular vapor deposition source, and a controllable source power supply for supplying the voltage.
